Europäisches Patentamt

European Patent Office

Office européen des brevets

(11) Publication number: **0 305 941 B1**

# EUROPEAN PATENT SPECIFICATION

(45) Date of publication of patent specification: **11.11.92** (51) Int. Cl.⁵: **H03K 3/289**

(21) Application number: **88114042.0**

(22) Date of filing: **29.08.88**

(54) **Flipflop which is operable at high speed and adapted to implementation as an integrated circuit.**

(30) Priority: **29.08.87 JP 214185/87**
**29.08.87 JP 214186/87**
**29.08.87 JP 214187/87**
**29.08.87 JP 214188/87**
**29.08.87 JP 214189/87**

(43) Date of publication of application:
**08.03.89 Bulletin 89/10**

(45) Publication of the grant of the patent:
**11.11.92 Bulletin 92/46**

(84) Designated Contracting States:
**DE FR GB**

(56) References cited:
**EP-A- 0 186 260**
**US-A- 4 289 979**

**REVIEW OF THE ELECTRICAL COMMUNICA-
TION LABORATORIES, vol. 26, no. 9-10,
September-October 1978, pages 1325-1338;
H. MUKAI et al.: "Master slice ECL LSI"**

**IBM TECHNICAL DISCLOSURE BULLETIN, vol.
30, no. 7, December 1987, pages 371-372,
Armonk, N.Y., US; "Harper cell with improved
soft error immunity"**

**REVIEW OF THE ELECTRICAL COMMUNICA-
TION LABORATORIES, vol. 26, no. 3-4, March-
April 1978, pages 539-546; T. NAKASHIMA et
al.: "LSI for D10 high speed central proces-
sor"**

**PATENT ABSTRACTS OF JAPAN, vol. 12, no.
20 (E-575)[2867], 21st January 1988;& JP-A-62
176 319**

(73) Proprietor: **NEC CORPORATION
7-1, Shiba 5-chome Minato-ku
Tokyo 108-01(JP)**

(72) Inventor: **Mano, Shigehiro
c/o NEC Corporation 33-1, Shiba 5-chome
Minato-ku Tokyo(JP)**

(74) Representative: **Betten & Resch
Reichenbachstrasse 19
W-8000 München 5(DE)**

EP 0 305 941 B1

## Description

BACKGROUND OF THE INVENTION:

This invention relates to a flipflop which comprises a master or first and a slave or second latch circuit and a selector circuit which is for use in selecting one of a plurality of input data for latch in the master and the slave latch circuits. Such a flipflop is preferred when the flipflop should be manufactured according to the integrated circuit technique. Master slave flipflops are described e.g. in US-A-4 289 979.

It will later be described more in detail in connection with a conventional flipflop of the type described that the master latch circuit has first and second master terminals and comprises differentially operable first and second primary master transistor circuits having first and second master nodes, respectively, a master resistor circuit between the first master terminal and the first and the second master nodes, and differentially operable first and second secondary master transistor circuits between the first and second primary master transistor circuits and the second master terminal. The slave latch circuit has first and second slave terminals and comprises differentially operable first and second primary slave transistor circuits having first and second slave nodes, respectively, a slave resistor circuit between the first slave terminal and the first and the second slave nodes, and differentially operable first and second secondary slave transistor circuits between the first and second primary slave transistor circuits and the second slave terminal. The selector circuit has first and second selector terminals and comprises a plurality of selector transistor circuits having a common node and connected to the second selector terminal, a selector resistor circuit between the first selecter terminal and the common node, and data signal terminals for supplying a plurality of input data to the respective selector transistor circuits.

A first power supply lead is connected to the first master, slave, and selector terminals. The selector transistor circuits have individual terminals which are collectively called the second selector terminal. A second power supply lead is connected to the second master and slave terminals and to the individual terminals through constant current sources, respectively. The power supply leads and the constant current sources therefore serve collectively as an arrangement for making master, slave, and selector constant currents flow between the first and the second master terminals through the master resistor circuit and the first and second primary and secondary master transistor circuits, between the first and the second slave terminals through the slave resistor circuit and the first and second primary and secondary slave transistor circuits, and between the first and the second selector terminals through each of the selector transistor circuits, respectively.

Select signal terminals are connected to the respective selector transistor circuits. Select signals are supplied to the respective select signal terminals to select one of the input data as a selected datum and to provide a selector output signal at the common node.

A clock terminal is connected to the first and second secondary master and slave transistor circuits. A clock signal is supplied to the clock terminal to latch a master input signal at the first and second master nodes as a master output signal and to latch a slave input signal at the first and second slave nodes as a slave output signal. In this manner, the clock terminal serves as a latching arrangement for latching the master and the slave input signals as the master and the slave output signals, respectively.

A selector to master signal delivering lead is used in delivering the selector output signal to the first and second primary master transistor circuits as the master input signal. A master to slave signal delivering lead is used to deliver the master output signal to the first and second primary slave transistor circuits as the slave input signal.

The first and the second primary slave transistor circuits comprise an input and a reference transistor which are differentially operable. Usually, each of the input and the reference transistors is an NPN transistor having base, emitter, and collector terminals. The collector terminals of the input and the reference transistors are connected to the first and the second slave nodes. The base terminal of the input transistor is supplied with the master output signal as the slave input signal. The base terminal of the reference transistor is supplied with a reference potential. When the slave input signal has a high level relative to the reference potential, the collector terminal of the input transistor is given a low level relative to the reference potential. The input transistor is therefore given a base potential which is considerably higher than its collector potential. As a result, the input transistor is inevitably put into a saturated state. This adversely affects high speed operation of the slave latch circuit.

Such facts are similar as regards an input transistor used in one of the first and the second primary master transistor circuits. High speed operation of the master latch circuit is also adversely affected. As a consequence, the conventional flipflop is not operable at high speed.

SUMMARY OF THE INVENTION:

It is therefore an object of the present invention to provide a flipflop which comprises a master and a slave latch circuit and in which the slave latch circuit is operable with high speed.

It is another object of this invention to provide a flipflop of the type described, in which the master latch circuit is operable at high speed.

It is still another object of this invention to provide a flipflop operable at high speed.

Other objects of this invention will become clear as the description proceeds.

It is possible on describing the gist of this invention to understand that a flipflop comprises a master and a slave latch circuit and a selector circuit. The master latch circuit comprises first and second master terminals, differentially operable first and second primary master transistor circuits having first and second master nodes, respectively, a master resistor circuit between the first master terminal and the first and second master nodes, and differentially operable first and second secondary master transistor circuits between the first and second primary master transistor circuits and the second master terminal. The slave latch circuit comprises first and second slave terminals, differentially operable first and second primary slave transistor circuits having first and second slave nodes, respectively, a slave resistor circuit between the first slave terminal and the first and second slave nodes, and differentially operable first and second secondary slave transistor circuits between the first and second primary slave transistor circuits and the second slave terminal. The selector circuit comprises first and second selector terminals, a plurality of selector transistor circuits having a common node and connected to the second selector terminal, a selector resistor circuit between the first selector terminal and the common node, and means for supplying a plurality of input data to the respective selector transistor circuits. The flipflop further comprises means for making master, slave, and selector constant currents flow between the first and the second master terminals through the master resistor circuit and the first and second primary and secondary master transistor circuits, between the first and the second slave terminals through the slave resistor circuit and the first and second primary and secondary slave transistor circuits, and between the first and the second selector terminals through the selector resistor circuit and each of the selector transistor circuits, respectively, selecting means connected to the selector transistor circuits for selecting one of the input data to provide a selector output signal at the common node, selector to master delivering means for delivering the selector output signal to the first and second primary master transistor circuits as a master input signal, latching means connected to the first and second secondary master and slave transistor circuits for latching the master input signal at the first and second master nodes as a master output signal and a slave input signal at the first and second slave nodes as a slave output signal, and master to slave delivering means for delivering the master output signal to the first and second primary slave transistor circuits as the slave input signal.

According to this invention, the above-understood flipflop is characterized in that the master resistor circuit comprises first and second master resistors having their one ends connected to the first and the second master nodes, respectively, and their other ends connected collectively to the first master terminal through a common master resistor.

BRIEF DESCRIPTION OF THE DRAWING:

Fig. 1 is a circuit diagram of a conventional flipflop;
Fig. 2 is a circuit diagram of a flipflop according to a first embodiment of the instant invention;
Fig. 3 is a circuit diagram of a flipflop according to a second embodiment of this invention;
Fig. 4 is a circuit diagram of a flipflop according to a third embodiment of this invention;
Fig. 5 is a circuit diagram of a flipflop according to a fourth embodiment of this invention; and
Fig. 6 is a circuit diagram of a flipflop according to a fifth embodiment of this invention.

DESCRIPTION OF THE PREFERRED EMBODIMENTS:

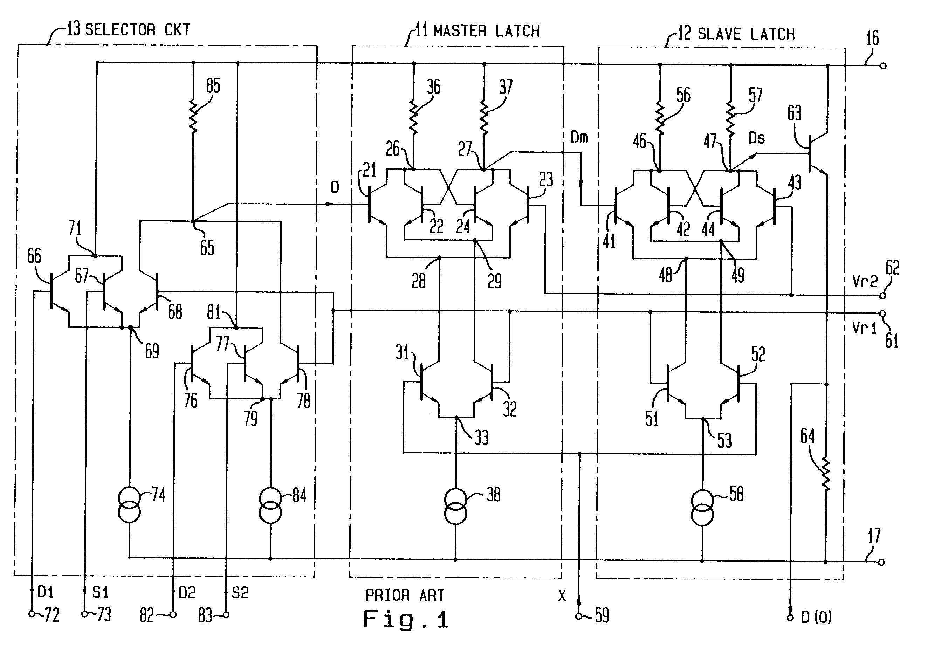

Referring to Fig. 1, a conventional flipflop will be described at first in order to facilitate an understanding of the present invention. The flipflop comprises a master or first latch circuit 11, a slave or second latch circuit 12, and a selector circuit 13. In other words, the flipflop is a master-slave flipflop which comprises the master and the slave latch circuits 11 and 12 and is accompanied by the selector circuit 13. The flipflop comprises first and second power supply leads 16 and 17 which are supplied with first and second source potentials, respectively. In the flipflop, each transistor is an NPN transistor having base, emitter, and collector terminals. Circuit elements are herein identified by using "master", "slave", and "selector" as modifiers when used in the master and the slave latch circuits 11 and 12 and in the selector circuit 13.

The master latch circuit 11 has a first master terminal connected to the first power supply lead 16 and a second master terminal which will presently be described. In the master latch circuit 11, a first primary master transistor circuit comprises an input master transistor 21 and a first primary master transistor 22. A second primary master transistor circuit comprises a reference master transistor 23 and a second primary master transistor 24. The collector terminals of the input master and the first primary master transistors 21 and 22 and the base terminal of the second primary master transistor 24 are connected together at a first master node 26. The collector terminals of the reference master and the second primary master transistors 23 and 24 and the base terminal of the first primary master transistor 22 are connected together at a second master node 27. The emitter terminals of the input master and the reference master transistors 21 and 23 are connected together at a first primary master emitter coupling 28. The emitter terminals of the first and the second primary master transistors 22 and 24 are connected together at a second primary master emitter coupling 29.

A first secondary master transistor circuit comprises a first secondary master transistor 31 and a second secondary master transistor circuit, a second secondary master transistor 32. The collector terminals of the first and the second secondary master transistors 31 and 32 are connected to the first and the second primary master emitter couplings 28 and 29, respectively. The emitter terminals of the first and the second secondary master transistors 31 and 32 are connected together at a single secondary master emitter coupling 33, which serves as the second master terminal.

A master resistor circuit comprises a first master resistor 36 between the first master terminal and the first master node 26 and a second master resistor 37 between the first master terminal and the second master node 27. A master constant current source 38 is interposed between the secondary master emitter coupling 33 and the second power supply lead 17.

The slave latch circuit 12 has a first slave terminal connected to the first power supply lead 16. In the slave latch circuit 12, a first primary slave transistor circuit comprises an input slave transistor 41 and a first primary slave transistor 42. A second primary slave transistor circuit comprises a reference slave transistor 43 and a second primary slave transistor 44. The collector terminals of the input slave and the first primary slave transistors 41 and 42 and the base terminal of the second primary slave transistor 44 are connected together at a first slave node 46. The collector terminals of the reference slave and the second primary slave transistors 43 and 44 and the base terminal of the first primary slave transistor 42 are connected together at a second slave node 47. The emitter terminals of the input slave and the reference slave transistors 41 and 43 are connected together at a first primary slave emitter coupling 48. The emitter terminals of the first and the second primary slave transistors 42 and 44 are connected together at a second primary slave emitter coupling 49.

A first secondary slave transistor circuit comprises a first secondary slave transistor 51 and a second secondary slave transistor circuit, a second secondary slave transistor 52. The collector terminals of the first and the second secondary slave transistors 51 and 52 are connected to the first and the second primary slave emitter couplings 48 and 49, respectively. The emitter terminals of the first and the second secondary slave transistors 51 and 52 are connected together at a single secondary slave emitter coupling 53, which serves as a second slave terminal.

A slave resistor circuit comprises a first slave resistor 56 between the first slave terminal and the first slave node 46 and a second slave resistor 57 between the first slave terminal and the second slave node 47. A slave constant current source 58 is interposed between the second slave terminal and the second power supply lead 17.

In the manner which will become clear as the description proceeds, the selector circuit 13 produces a selector output signal or datum D which varies between a high and a low logic level and is delivered to the base terminal of the input master transistor 21 as a master input signal. The master latch circuit 11 latches the master input signal at the first and the second master nodes 26 and 27. In the example being illustrated, the master latch circuit 11 produces a master output signal Dm which is the master input signal latched at the second master node 27 and is delivered to the base terminal of the input slave transistor 41 as a slave input signal. Inasmuch as the master and the slave input signals are the selector and the master output signals D and Dm as they stand, the master and the slave input signals will be denoted by D and Dm. The slave latch circuit 12 latches the slave input signal Dm at the first and the second slave nodes 46 and 47. In the illustrated example, the slave latch circuit 12 produces a slave output signal Ds which is the slave input signal Dm latched at the second slave node 47. Each of the master and the slave output signals Dm and Ds has either a high or a low logic level.

In general, a clock signal X is necessary in putting a flipflop into operation. The clock signal X has a high and a low level and varies between the high and the low levels with a clock period. For the flipflop being illustrated, the clock signal X is supplied to a clock terminal 59 which is connected to the base terminals of the first secondary master and the second secondary slave transistors 31 and 52. A first reference potential Vr1 has a direct current level which is equal to a midpoint between the high and the low levels of the clock signal X. The first reference potential Vr1 is supplied to a first reference potential terminal 61 connected to the base terminals of the second secondary master and the first secondary slave transistors 32 and 51. A second reference potential Vr2 has a direct current level which is equal to a midpoint between the high and the low logic levels of the master and the slave input signals D and Dm. The second reference potential Vr2 is supplied to a second reference potential terminal 62 connected to the base terminals of the reference master and slave transistors 23 and 43.

The first and the second primary master transistor circuits are differentially operable. This applies to the first and the second secondary master transistor circuits, the first and the second primary slave transistor circuits, and the first and the second secondary slave transistor circuits. In the master latch circuit 11, the master input signal D is latched at the master nodes 26 and 27 when the clock signal X builds down from the high level to the low level for the first time after the master input signal D is delivered to the master latch circuit 11. The master output signal Dm is related to the master input signal D according to positive logic. At the slave nodes 46 and 47, the slave input signal Dm is latched when the clock signal X builds up from the low level to the high level for the first time after the slave input signal Dm is delivered to the slave latch circuit 12. The slave output signal Ds is related to the slave input signal Dm according to positive logic. Incidentally, the master input signal D is latched at the first master node 26 according to negative logic relative to the master input signal D. The slave input signal Dm is latched at the first slave node 46 according to negative logic relative to the slave input signal Dm.

Each of the master and the slave latch circuits 11 and 12 is a two-stage emitter-coupled logic circuit. More particularly, the master latch circuit 11 has two emitter couplings 28 and 33 or 29 and 33 in series between the first and the second master terminals. Similarly, the slave latch circuit 12 has two emitter couplings 48 and 53 or 49 and 53 in series between the first and the second slave terminals and is another two-stage emitter-coupled logic circuit. "Emitter-coupled logic" is often abbreviated to ECL.

The flipflop is for latching a plurality of input data selectively one at a time. The selector circuit 13 is for use in selecting one of the input data at a time as a selected datum to produce the selected datum as the above-mentioned selector output signal or datum D. The flipflop is therefore for latching the selected datum in the master and the slave latch circuits 11 and 12 to produce the master and the slave output signals Dm and Ds. In practice, the slave latch circuit 12 comprises an emitter follower for producing the slave output signal Ds as a flipflop output signal D(0). The emitter follower comprises an emitter follower NPN transistor 63 which has a base terminal supplied with the slave output signal Ds, a collector terminal connected directly to the first power supply lead 16, and an emitter terminal connected to the second power supply lead 17 through an emitter follower resistor 64. The flipflop output signal D(0) is obtained at a point of connection between the emitter terminal of the emitter follower NPN transistor 63 and the emitter follower resistor 64.

The selector circuit 13 has a first selector terminal connected to the first power supply lead 16 and a second selector terminal which will shortly be described. The selector circuit 13 comprises a plurality of selector transistor circuits which are equal in number to the input data and have a common node 65 and individual terminals, which collectively serve as the second selector terminal. A plurality of select signals, corresponding to the respective input data, are used in making the selector circuit 13 select the selected datum. Each select signal has a high and a low level. For the selector circuit 13 being illustrated, the low level is given to one only of the select signals in correspondence to one of the input data that should be selected as the selected datum. Other select signals are given the high level. The selector transistor circuits are therefore exclusively operable. Each selector transistor circuit is a single-stage emitter-coupled logic circuit and serves as a gate circuit.

In the example being illustrated, the selector transistor circuits are equal in number to two and consists of first and second selector transistor circuits. It will now be assumed that the clock signal X, the input data, and the select signals have the high and the low levels in common.

The first selector transistor circuit comprises a first input transistor 66, a first selection transistor 67, and a first reference transistor 68 which have the emitter terminals connected together at a first selector emitter coupling 69. The collector terminals of the first input and selection transistors 66 and 67 are connected together at a first collector coupling 71, which is directly connected to the first power supply lead 16. The collector terminal of the first reference transistor 68 is connected to the common node 65. The emitter coupling 69 serves as one of the individual terminals that the first selector transistor circuit has. The first selector transistor circuit is therefore connected to the second selector terminal.

The base terminal of the first input transistor 66 is supplied with a first input datum D1 through a first data input terminal 72 which will hereafter be referred to briefly as a first data terminal 72. The base terminal of the first selection transistor 67 is supplied with a first select signal S1 through a first select signal terminal 73 which will be briefly called a first select terminal 73 hereunder. The base terminal of the first reference transistor 68 is supplied with the first reference potential Vr1 through the first reference potential terminal 61. A first selector constant current source 74 is interposed between the first selector emitter coupling 69 and the second power supply lead 17.

The second selector transistor circuit comprises a second input transistor 76, a second selection transistor 77, and a second reference transistor 78 which have the emitter terminals connected together at a second selector emitter coupling 79. Like in the first selector transistor circuit, the collector terminals of the second input and selection transistors 76 and 77 are connected together at a second collector coupling 81, which is connected directly to the first power supply lead 16. The collector terminal of the second reference transistor 78 is connected to the common node 65. The base terminal of the second input transistor 76 is supplied with a second input datum D2 through a second data terminal 82. The base terminal of the second selection transistor 77 is supplied with a second select signal S2 through a second select terminal 83. The base terminal of the second reference transistor 78 is supplied with the first reference potential Vr1. A second selector constant current source 84 is interposed between the second selector emitter coupling 79 and the second power supply lead 17.

A selector resistor circuit is connected between the first selector terminal and the selector transistor circuits. In the selector circuit 13 being illustrated, the selector resistor circuit comprises a selector resistor 85 alone between the first power supply lead 16 and the common node 65. Incidentally, the selector constant current sources, such as 74 and 84, are for selector constant currents which have a common selector constant current value.

In the conventional flipflop, the master, the slave, and the selector output signals Dm, Ds, and D have the high and the low logic levels in common. Attention will be directed to the slave latch circuit 12. When the slave input signal Dm rises above the second reference potential Vr2 towards the high logic level, the input slave and the reference slave transistors 41 and 43 are turned into an on and an off state, respectively. The first slave node 46 is given the low logic level and the second slave node 47, the high logic level. Under the circumstances, the input slave transistor 41 has a base potential given by the high logic potential of the slave input signal Dm and a collector potential which is equal to the low logic level given to the slave output signal Ds. The input slave transistor 41 is therefore put into a saturated state to give a long signal propagation delay to the slave latch circuit 12. In other words, the slave latch circuit 12 is not operable at high speed.

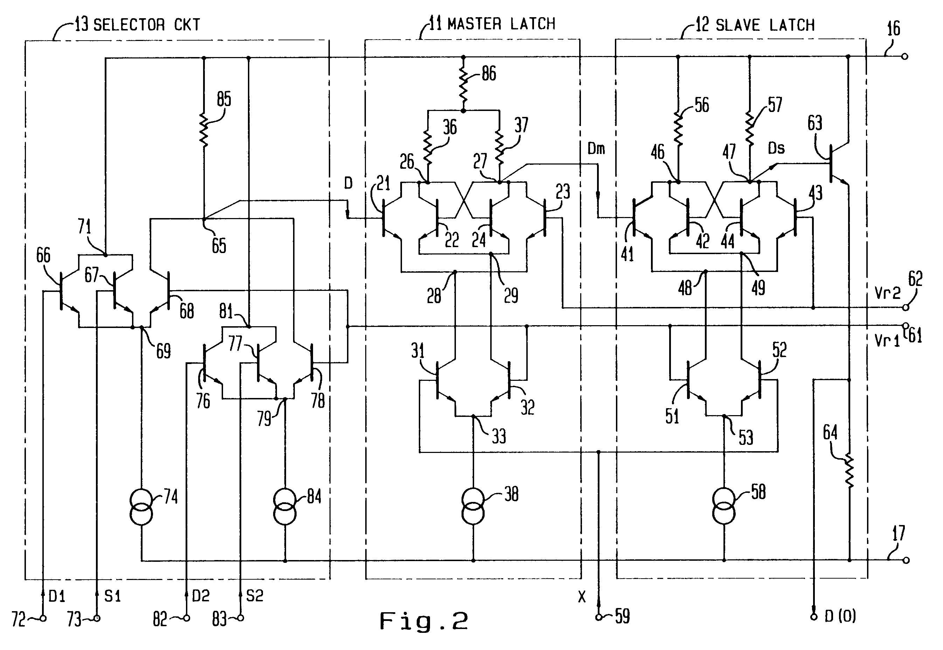

Referring now to Fig. 2, the description will proceed to a flipflop according to a first embodiment of the present invention. The flipflop comprises similar parts which are designated by like reference numerals and are operable with likewise named and denoted signals.

It should be noted in connection with the master latch circuit 11 that the first and the second master resistors 36 and 37 have their ends which are not directly connected to the first power supply lead 16 but are connected together and indirectly to the first power supply lead 16 through a common master resistor 86. Stated otherwise, the master resistor circuit comprises the first and the second master resistors 36 and 37 having their one ends connected to the first and the second master nodes 26 and 27, respectively, and their other ends connected collectively to the first master terminal through the common master resistor 86. In other respects, the flipflop is not different in structure from the conventional one. Operation will now be described a little more in detail.

For the selector circuit 13, it will be presumed that the first select signal S1 alone is given the low level and the other select signals, such as the second select signal S2, the high level. In this event, only one of the reference transistors, such as 68 and 78, is rendered on and off while other reference transistor or transistors are kept off in the manner which will presently become clear.

The only one reference transistor is rendered on and off by one of the input data that is selected by the low-level select signal as the selected datum. The selector resistor 85 is connected only to the reference transistors, such as 68 and 78, in the selector circuit 13. As a consequence, the selector constant current does not flow through the selector resistor 85 when the only one reference transistor is in an off state. When the only one reference transistor is turned into an on state, the selector constant current flows from the first power supply lead 16 to the second power supply lead 17 through the selector resistor 85, the only one reference transistor, and one of the selector constant current sources, such as 74 and 84, that is interposed between the only one reference transistor and the second power supply lead 17.

The base terminal of the first selection transistor 67 is given a lower level than the base terminal of the first reference transistor 68. If the first input transistor 66 were not included in the first selector transistor circuit, the first reference transistor 68 would be kept in the off state. The first reference transistor 68 is, however, put in the on and the off states depending on the first input datum D1.

When the first input datum D1 has the high level, the first reference transistor 68 is put in the off state and the first input transistor 66, in the on state. When the first input datum D1 has the low level, the first reference transistor 68 is put in the on state and the first input transistor 66, in the off state. In either event, the first selection transistor 67 is kept in the off state. The selector constant current therefore flows through the first input transistor 66 and flows through the selector resistor 85 and the first reference transistor 68 when the first input datum D1 has the high and the low levels, respectively.

Inasmuch as the base terminal of the second selection transistor 77 is given a higher level than the base terminal of the second reference transistor 78, the second selection transistor 77 is rendered on and the second reference transistor 78, off. The selector constant current flows through the second selection transistor 77. No current flows through the selector resistor 85 and the second reference transistor 78 irrespective of the high and the low levels of the second input datum D2.

When the first input datum D1 has the high level, no current flows through the selector resistor 85 and either of the first and the second reference transistors 68 and 78. The common node 65 is given a higher logic level. When the first input datum D1 has the low level, the selector constant current flows from the first power supply lead 16 only to the first selector constant current source 74 through the selector resistor 85 and the first reference transistor 68. The common node 65 is given a lower logic level. The selector output signal or datum D therefore appears at the common node 65 according to positive logic with respect to the first input datum D1.

Attention will be directed to the master latch circuit 11. It will be assumed at first that the clock signal X has the high level at a certain instant of time. The base terminal of the first secondary master transistor 31 is given a higher level than the base terminal of the second secondary master transistor 32. The first secondary master transistor 31 is put in the on state. A master constant current therefore flows through the first secondary master transistor 31 from the first primary master emitter coupling 28 to the master constant current source 48 with a master constant current value. The second secondary master transistor 32 is put in the off state. No current therefore flows from the second primary master emitter coupling 29 to the master constant current source 48. The first primary master emitter coupling 28 is in a current path and the second primary master emitter coupling 29, not in a current path.

When the master input signal D has the high logic level, the base terminal of the input master transistor 21 is given a higher level than the base terminal of the reference master transistor 23. The input master transistor 21 is put in the on state and the reference master transistor 23, in the off state. The master constant current therefore flows from the first power supply lead 16 to the first primary master emitter coupling 28 successively through the common master resistor 86, the first master resistor 36, and the input master transistor 21. No current flows through the second master resistor 37 and the reference master transistor 23. As a result, the first master node 26 is given a lower master logic level and the second master node 27, a higher master logic level.

Inasmuch as the base terminal of the first primary master transistor 22 is given the higher master logic level, the first primary master transistor 22 is put in the on state. The master constant current would therefore flow also through the first primary master transistor 22 to the second primary master emitter coupling 29. No current, however, flows through the first primary master transistor 22 in practice because the second primary master emitter coupling 29 is not in the current path under the circumstances. Being given the lower master logic level to the base terminal, the second primary master transistor 24 is put in the off state. As a result, no current flows through the first and the second primary master transistors 22 and 24.

It will now be assumed that the clock signal X builds down from the high level to the low level. The master constant current is switched from the first secondary master transistor 31 to the second secondary master transistor 32 to flow from the second primary master emitter coupling 29 to the master constant current source 48 with the master constant current value. The first primary master emitter coupling 28 is put out of the current path. Instead, the second primary master emitter coupling 29 is put in the current path.

When the master input signal D has the high logic level, the first primary master transistor 22 is in the on state as before. The second primary master transistor 24 is kept in the off state. Inasmuch as the second primary master emitter coupling 29 is now put in the current path, the master constant current flows from the first power supply lead 16 to the second primary master emitter coupling 29 successively through the common master resistor 86, the first master resistor 36, and the first primary master transistor 22. No current flows through the second master resistor 37 and either of the reference master transistor 23 and the second primary master transistor 24. As a result, the master input signal D is latched at the first and the second master nodes 26 and 27 as first and second master latched signals, respectively, when the clock signal X builds down.

It will again be assumed that the clock signal X has the high level. As before, the first primary master emitter coupling 28 is in the current path. The second primary master emitter coupling 29 is not.

When the master input signal D has the low logic level, the input master transistor 21 is put in the off state and the reference master transistor 23, in the on state. The master constant current therefore flows from the first power supply lead 16 to the first primary master emitter coupling 28 successively through the common master resistor 86, the second master resistor 37, and the reference master transistor 23. No current flows through the first master resistor 36 and the input master transistor 21. As a result, the first master node 26 is given the lower master logic level and the second master node 27, the higher master logic level. Inasmuch as the second primary master emitter coupling 29 is not in the current path, no current flows through the first and the second primary master transistors 22 and 24.

It will be assumed once more that the clock signal X builds down. The first primary master emitter coupling 28 is put out of the current path. Instead, the second primary master emitter coupling 29 is put in the current path.

When the master input signal D has the low logic level, the master constant current flows from the first power supply lead 16 to the second primary master emitter coupling 29 successively through the common master resistor 86, the second master resistor 37, and the second primary master transistor 24. No current flows through the first master resistor 36 and either through the input master transistor 21 or through the first primary master transistor 22. As a result, the master input signal D is latched at the first and the second master nodes 26 and 27 as the first and the second master latched signals, respectively, when the clock signal X builds down.

It will now be understood that the first master latched signal has the lower and the higher master logic levels which are related to the master input signal D according to negative logic. The second master latched signal has the higher and the lower master logic levels which are related to the master input signal D according to positive logic. Incidentally, the master constant current flows through one only of the first and the second primary master transistor circuits and one only of the first and the second secondary master transistor circuits at a time. It is, however, understood that the master constant current flows through the first and the second primary and secondary master transistor circuits when at least one clock period is taken into consideration.

The slave latch circuit 12 is similar in structure to the master latch circuit 11. A slave constant current flows from the first power supply lead 16 to the second power supply lead 17 with a slave constant current value. It will be assumed that the clock signal X has the low level. When the slave input signal Dm has the higher master logic level, the slave constant current flows successively through the first slave resistor 56, the input slave transistor 41, the first secondary slave transistor 51, and the slave constant current source 58. When the slave input signal Dm has the lower master logic level, the slave constant current flows successively through the second slave resistor 57, the reference slave transistor 43, the first secondary slave transistor 51, and the slave constant current source 58.

It should be understood in this connection that the first primary slave emitter coupling 48 is connected to the first secondary slave transistor 51 which is supplied with the first reference potential Vr1 rather than with the clock signal X. The second primary slave emitter coupling 49 is controlled by the second secondary slave transistor 52 which is not supplied with the first reference potential Vr1 but with the clock signal X. The slave input signal Dm is therefore latched at the first and the second slave nodes 46 and 47 as first and second slave latched signals, respectively, when the clock signal X builds up from the low level to the high level.

For the differential operation, the first and the second slave resistors 56 and 57 should have a common slave resistance value Rs and the first and the second master resistors 36 and 37, a common master resistance value Rm. The slave, the master, and the selector constant currents may have a common flipflop constant current value I. Under the circumstances, each of the first and the second slave latched signals has a higher slave logic level and a lower slave logic level which are substantially equal to the first source potential itself and the first source potential minus a slave potential drop Rsl. When the common master resistor 86 has a predetermined master resistance value Rpm, the higher master logic level is substantially equal to the first source potential minus a smaller master potential drop Rpml and the lower master logic level, to the first source potential minus a greater master potential drop (Rpm + Rm)l. The higher master logic level is shifted towards the lower master or slave logic level by a master level shift which is equal to the smaller master potential drop Rpml.

In the conventional flipflop, the master output signal Dm has a conventional higher logic level which is substantially equal to the first source potential as it stands. The input slave transistor 41 therefore has a base potential and a collector potential which are substantially equal to the first source potential itself and the first source potential less the slave potential drop Rsl. The base potential is considerably higher than the collector potential.

In contrast, the base potential is substantially equal in Fig. 2 to the first source potential less the smaller master potential drop Rpml. The collector potential is substantially equal to the first source potential less the slave potential drop Rsl. The base potential is therefore not so high as to put the input slave transistor 41 in the saturated state. This avoids undesirable saturation of the input slave transistor 41. The slave latch circuit 12 is operable at high speed.

Between the higher and the lower slave logic levels, the slave output signal Ds has a slave logic amplitude which is substantially equal to the slave potential drop Rsl. The master output signal Dm has a master logic amplitude which is substantially equal to a master potential difference Rml between the smaller and the greater master potential drops. It is now possible to make the master output signal Dm have a smaller logic amplitude than the slave output signal Ds by using the common master resistance value Rm which is smaller than the common slave resistance value Rs.

It is preferred to use the second reference potential Vr2 in common in the master and the slave latch circuits 11 and 12. For this purpose, the master logic amplitude should be substantially equal to the slave logic amplitude less the master level shift Rpml. Preferably, the master logic amplitude should be a half of the slave logic amplitude. In other words, the common master resistance value Rm should be a half of the common slave resistance value Rs. The predetermined master resistance value Rpm should be a half of the common master resistance value Rm.

Incidentally, the common selector constant current value is usually equal to the common flipflop constant current value I. In this event, it is preferred that the selector resistor 85 should have a selector resistance value which is substantially equal to the common slave resistance value Rs. The higher selector logic level is equal to the first source potential as it is. The lower selector logic level is substantially equal to the first source potential minus a selector potential drop which is equal to the slave potential drop Rsl.

In the conventional flipflop, the input master transistor 21 has a base potential and a collector potential which are substantially equal to the first source potential itself and the first source potential minus the selector potential drop Rsl. Like in the slave latch circuit 12, the base potential of the input master transistor 21 is considerably higher than its collector potential.

In contrast, the base potential is substantially equal in the master latch circuit 11 described in conjunction with Fig. 2 to the first source potential as it stands when the selector output signal D is delivered to the base terminal of the input master transistor 21 with the higher selector logic level. In this event, the collector potential is substantially equal to the first source potential less the greater master potential drop (Rpm + Rm)I, which is smaller than the selector potential drop Rsl. The base potential is therefore not so high as to put the input master transistor 21 in a saturated state. This avoids undesirable saturation of the input master transistor 21. The master latch circuit 11 is operable at high speed. After all, the flipflop is operable at high speed.

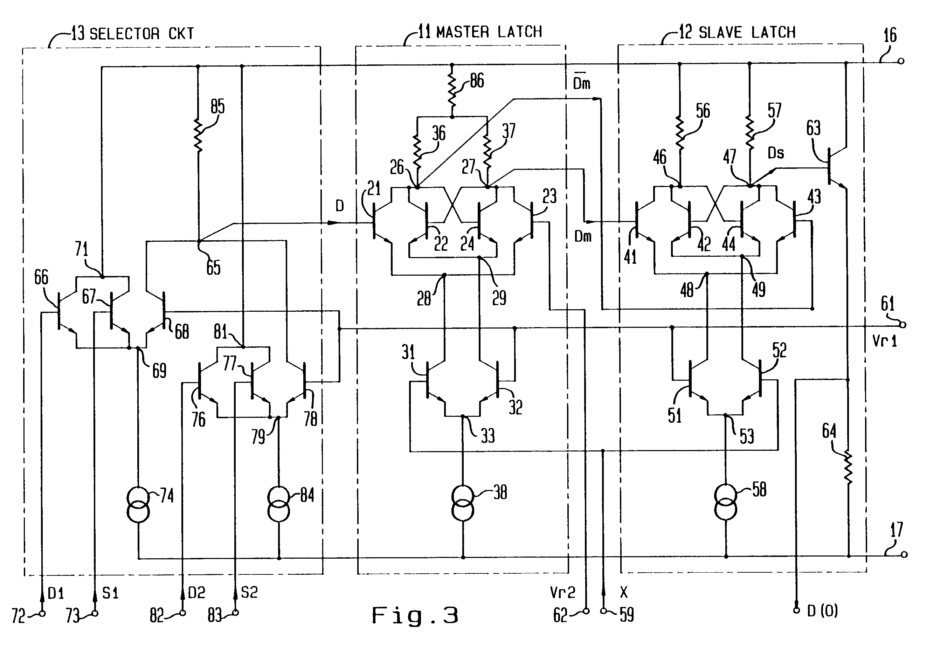

Turning to Fig. 3, the description will be directed to a flipflop according to a second embodiment of this invention. The flipflop comprises similar parts which are designated by like reference numerals and are operable with likewise named and denoted signals.

The second reference potential Vr2 is used only in the master latch circuit 11. As in the conventional flipflop and in the flipflop illustrated with reference to Fig. 2, the second master latched signal is delivered to the base terminal of the input slave transistor 41 as the slave input signal Dm. Instead of the second reference potential Vr2, the first master latched signal is delivered to the base terminal of the reference slave transistor 43 as a reference for the slave input signal Dm. In other words, the first and the second master latched signals are delivered to one and the other of the first and the second primary slave transistor circuits as the slave input signal Dm and the reference therefor. In this manner, the first and the second master latched signals are used as a pair of balanced input signals of the slave latch circuit 12. As for the master latch circuit 11, the selector output signal D is delivered to one of the first and the second primary master transistor circuits like in the master latch circuit 11 described above in connection with Fig. 1 or 2.

In the manner described before, the master output signal Dm has a smaller logic amplitude in the flipflop being illustrated than in the conventional flipflop. For example, the logic amplitude is a half of the conventional one. In the flipflop illustrated with reference to Fig. 2, use of the slave input signal Dm of this small logic amplitude adversely affects margins against noise, fluctuations in the second reference potential Vr2, and others. In contrast, the first master latched signal is used in Fig. 3 as the reference for the slave input signal Dm which is the second master latched signal. This insures the margins. The flipflop being illustrated is therefore operable stably and at high speed.

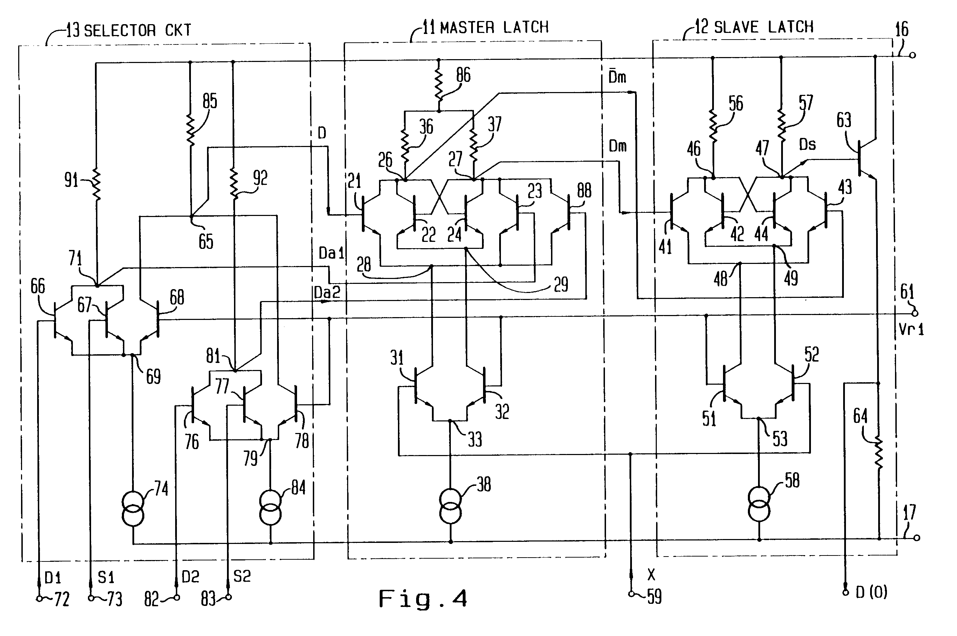

Referring to Fig. 4, the description will proceed to a flipflop according to a third embodiment of this invention. The flipflop comprises similar parts which are again designated by like reference numerals and are operable with likewise named and denoted signals.

As in Fig. 3, the second and the first master latched signals are used as the slave input signal Dm and the reference for the slave input signal Dm, respectively. In addition, the selector circuit 13 is improved to an appreciable extent. The master latch circuit 11 is modified accordingly.

More specifically, the selector resistor 85 will now be named a single resistor 85. The selector transistor circuits have individual nodes, respectively, besides the common node 65 in common. Individual resistors are interposed between the first selector terminal and the respective individual nodes. Like in the conventional flipflop and in the flipflops illustrated with reference to Figs. 2 and 3, the selector output signal D is produced at the common node 65 according to positive logic relative to the selected datum. Moreover, an additional output signal is produced according to negative logic relative to the selected datum at one of the individual nodes that is had by one of the selector transistor circuits to which the low-level select signal is supplied for selection of the selected datum. As before, the selector output signal D is delivered to one of the first and the second primary master transistor circuits directly as the master input signal D. The additional output signal is delivered to the other of the first and the second primary master transistor circuits through a NOR gate for use as a reference for the master input signal D. This makes is unnecessary to use the second reference potential Vr2.

In the illustrated selector circuit 13 which comprises only the first and the second selector transistor circuits, the individual nodes are two in number. First and second additional output signals Da1 and Da2 are produced at the respective individual nodes and are delivered to the second primary master transistor circuit. In addition to the reference master transistor 23 which will now be referred to afresh as a first reference transistor 23, a second reference transistor 88 is included in the second primary master transistor circuit. The base terminals of the first and the second reference transistors 23 and 88 are supplied with the first and the second additional signals Da1 and Da2. The collector terminal of the second reference transistor 88 is connected to the second master node 27 and its emitter terminal, to the first primary master emitter coupling 28. The first and the second reference transistors 23 and 28 collectively serve as a NOR gate.

In the selector circuit 13, first and second individual resistors 91 and 92 are interposed between the first power supply lead 16 and the first and the second collector couplings 71 and 81. This makes the first and the second collector couplings 71 and 81 serve as first and second individual nodes, which will be designated by the reference numerals 71 and 81 of the respective collector couplings.

In operation, the selector output signal D is produced at the common node 65 as before according to positive logic in relation to the selected datum. It will again be surmised that the first select signal S1 alone is given the low level with the high level given to each of other select signals, such as S2. When the first input datum D1 has the high level, the selector constant current flows from the first power supply lead 16 to the first selector constant current source 74 successively through the first individual resistor 91 and the first input transistor 66. When the first input datum D1 has the low level, no current flows through the first individual resistor 91. The first additional output signal Da1 is therefore given a low and a high logic level when the first input datum D1 has the high and the low levels, respectively. In this manner, the first additional output signal Da1 is related to the first input datum D1 according to negative logic. Furthermore, the selector constant current flows from the first power supply lead 16 to the second selector constant current source 84 successively through the second individual resistor 92 and the second selection transistor 77. The second additional output signal Da2 is kept at the low logic level no matter whichever of the high and the low levels the second datum D2 has.

It is now understood when one of the input data is selected as the selected datum that the high and the low logic levels are given in correspondence to the low and the high levels of the selected datum to one only of the additional output signals Da1 and Da2 that is produced at the individual node the selector transistor circuit has by which the selected datum is selected. Other additional output signal or signals are kept at the low logic level. Incidentally, use of the individual resistors, such as 91 and 92, avoids application of the first and the second source potentials across the selector constant current sources, such as 74 and 84.

It will be understood as before that the common selector constant current value is equal to the common flipflop constant current value. The common slave resistance value Rs will be given to each of the individual resistors, such as 91 and 92. When the first selection signal S1 alone has the low level, the first additional output signal Da1 is given the high and the low logic levels which are substantially equal to the first source potential itself and the first source potential minus the selector potential drop RsI, namely, which are equal to the higher and the lower selector logic levels. Other additional output signals, such as Da2, are kept at the lower selector logic level.

When the first input datum D1 is selected and has the low level, the base terminal of the input master transistor 21 is given the lower selector logic level. The base terminal of the first reference transistor 23 is given the higher selector logic level of the first additional output signal Da1 and the base terminal of the second reference transistor 88, the lower selector logic level of the second additional output signal Da2. The input master transistor 21 is put in the off state and the first reference transistor 23, in the on state. It does not matter in whichever of the on and the off states the second reference transistor 88 may be put. It will readily be understood when the first input datum D1 is selected and has the high level that the input master transistor 21 is put in the on state and each of the first and the second reference transistors 23 and 88, in the off state. This operation equally applies even when the selector circuit 13 comprises more than two selector transistor circuits and even when any one of the input data is selected.

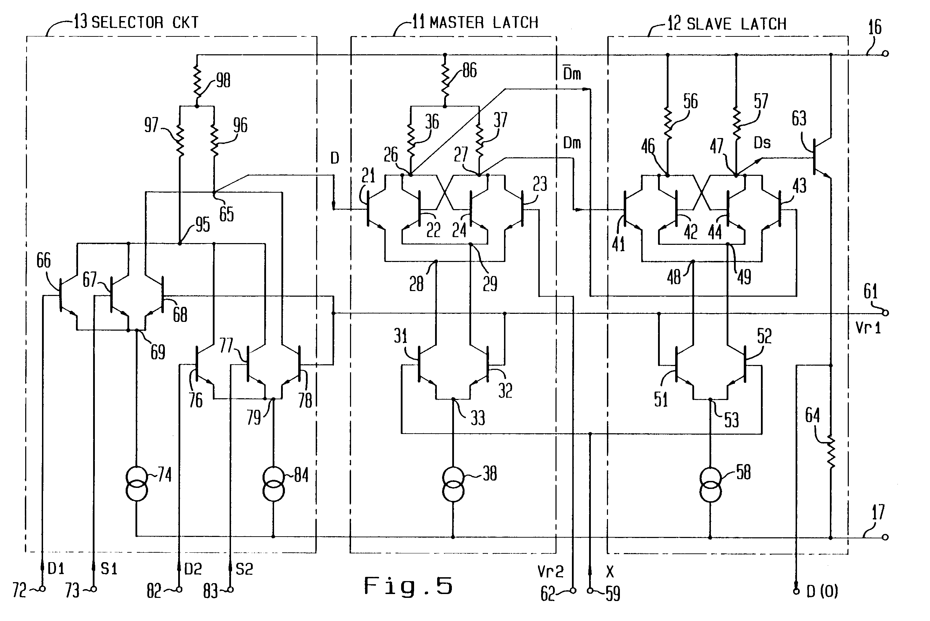

Referring now to Fig. 5, the description will proceed to a flipflop according to a fourth embodiment of this invention. The flipflop comprises similar parts which are once more designated by like reference numerals and are operable with likewise named and denoted signals.

The flipflop is similar in structure to that illustrated with reference to Fig. 3. The selector circuit 13 is, however, improved to a considerable extent in the manner which is different from the selector circuit 13 described above in conjunction with Fig. 4.

When described in general, the selector transistor circuits have an additional node 95 in common besides the common node 65. From a different point of view, the additional node 95 is a combination of the individual nodes, such as 71 and 81, described in connection with Fig. 4. The selector resistor circuit comprises first and second selector resistors 96 and 97 which have their one ends connected to the common and the additional nodes 65 and 95, respectively, and their other ends connected collectively to the first power supply lead 16, namely, to the first selector terminal, indirectly through a common selector resistor 98. As before, the selector output signal D is produced at the common node 65 according to positive logic in relation to the selected datum. In addition to the selector output signal D, an additional output signal Da is produced at the additional node 95 in accordance with negative logic relative to the selected datum.

As before, the selector output signal D is delivered to one of the first and the second primary master transistor circuits. The additional output signal Da is, however, not positively used in Fig. 5 despite the above-mentioned improvement of the selector circuit 13. The improvement nevertheless makes it possible to avoid saturation of an input transistor which is used in the first or the second primary master transistor circuit and is supplied with the selector output signal D. This is because the common selector resistor 98 is operable like the common master resistor 86 in the manner which will be described a little later in the following.

In operation, it will be presumed that the selector transistor circuits are N in number, where N represents a predetermined natural number which is greater than one. The first and the second selector resistors 96 and 97 will be given first and second selector resistance values Rs1 and Rs2 and the common selector resistor 98, a predetermined selector resistance value Rps. The common selector constant current value will be given the common flipflop constant current value I. The first reference transistor 68 and other reference transistor such as the second reference transistor 78, will be called selector reference transistors, respectively. The first selection transistor 67 and other selection transistors, such as the second selection transistor 77, will be referred to as remaining selection transistors when a particular selection transistor is excluded.

It will be surmised as before that the first select signal S1 alone is given the low level with the high level given to each of other select signals. The first selection transistor 67 becomes the particular selection transistor.

When the first input datum D1 has the high level, the selector constant currents flow from the first power supply lead 16 to the respective selector constant current sources, such as 74 and 84, as follows. Among the selector constant currents, a first particular constant current flows successively through the common selector resistor 98, the second selector resistor 97, and the first input transistor 66. A second particular constant current flows neither through the second selector resistor 97 nor the first selection transistor 67. Other selector constant currents flow successively through the common selector resistor 98, the second selector resistor 97, and the respective remaining selection transistors. No selector constant current flows through the first selector resistor 96 and each of the selector reference transistors. As a consequence, the selector constant currents of a total sum value NI flow through the common selector resistor 98 and the second selector resistor 97.

The common node 65 is subjected to a first smaller potential drop Vs1 which is equal to NRpsI. A second smaller potential drop Vs2 will shortly be described. The additional node 95 is subjected to a second greater potential drop Vg2 which is equal to N(Rps + Rs2)I.

When the first input datum D1 has the low level, the selector constant currents flow from the first power supply lead 16 to the respective selector constant current sources as follows. The first particular constant current does not flow. The second particular constant current does neither flow. Instead, a third particular constant current flows successively through the common selector resistor 98, the first selector resistor 96, and the first reference transistor 68. The other selector constant currents flow as above. Consequently, the selector constant currents of the total sum value NI flow through the common selector resistor 98. The third particular constant current of the common flipflop constant current value I flows through the first selector resistor 96. The other selector constant currents of a partial sum value (N - 1)I flow through the second selector resistor 97.

The common node 65 is subjected to a first greater potential drop Vg1 which is equal to (NRps + Rs1)I. The additional node 96 is subjected to the second smaller potential drop Vs2 which is equal to [NRps + (N - 1)Rs2]I.

It is now understood in general that the selector output signal D has first high and low logic levels which are related to the selected datum according to the positive logic and are substantially equal to the first source potential minus the first smaller and greater potential drops Vs1 and Vg1, respectively. The selector output signal D has a first logic amplitude which is equal to Rs1I. The additional output signal Da has second high and low logic levels which are related to the selected datum according to the negative logic and are substantially equal to the first source potential minus the second smaller and greater potential drops Vs2 and Vg2, respectively. The additional output signal Da has a second logic amplitude which is equal to Rs2I. The first logic amplitude will readily be understood when the first selector resistor 96 is taken into consideration together with the third particular constant current which alone flows through the first selector resistor 96. The second logic amplitude will similarly be understood when attention is directed to the second selector resistor 97 through which the first particular constant current flows and does not flow.

When compared with the selector output signal D which is used in the conventional flipflop and each of the flipflops illustrated with reference to Figs. 2 through 4, the selector output signal D has in Fig. 5 the first high logic level which is subjected to a selector level shift towards the first lower logic level and also towards the lower master logic level. The selector level shift is equal to the first smaller potential drop NRpsI.

It is described above in connection with Fig. 2 to render the common master resistance value Rm equal to a half of the common slave resistance value Rs and the predetermined master resistance value Rpm, equal to a half of the master resistance value Rm. Attention will be directed to the input master transistor 21 described in conjunction with each of Figs. 2 through 4. When the master input signal D has the higher selector logic level, its base potential is substantially equal to the first source potential as it is. Its collector potential is substantially equal to the first source potential less the greater master potential drop (Rpm + Rm)I.

In contrast, attention will be directed to the input master transistor 21 used in the flipflop being illustrated. When the master input signal D has the first high logic level, its base potential is substantially equal to the first source potential less the first smaller potential drop NRpsI. In this event, its collector potential remains substantially equal to the first source potential less the greater master potential drop (Rpm + Rm)I. The base potential is lower by the first smaller potential drop NRpsI than that used in each of the flipflops illustrated with reference to Figs. 2 through 4. The input master transistor 21 is therefore more reliably prevented from being saturated than the input master transistor 21 described in connection with Figs. 2 through 4.

Consideration will now be given to the second reference potential Vr2. In the flipflop illustrated with reference to Fig. 3 and in the flipflop being illustrated, the second reference potential Vr2 is supplied to one of the first and the second primary master transistor circuits alone. If it is desired to use the second reference potential Vr2 described in conjunction with Figs. 1 and 2, either the selector resistance value Rs or a combination of the predetermined and the first selector resistance values Rps and Rs1 should be determined accordingly. Alternatively, it is possible to optionally determine a selector output midpoint between the higher and the lower selector logic levels or between the first high and low logic levels of the selector output signal D and to use the selector output midpoint as the second reference potential Vr2.

For example, the first selector resistance value Rs1 may be equal to either the common master resistance value Rm or the common slave resistance value Rs. The predetermined selector resistance value Rps may be equal to either a half or an N-th part of the first selector resistance value Rs1. It is possible to make the selector output signal D have a smaller logic amplitude than the slave output signal Ds when the first selector resistance value Rs1 is rendered smaller than the common slave resistance value Rs. The selector level shift becomes equal to the master level shift when the predetermined selector resistance value Rps is rendered equal to the N-th part of the common master resistance value Rm. Incidentally, it is possible to use the additional output signal Da alone, instead of the selector output signal D, as the master input signal.

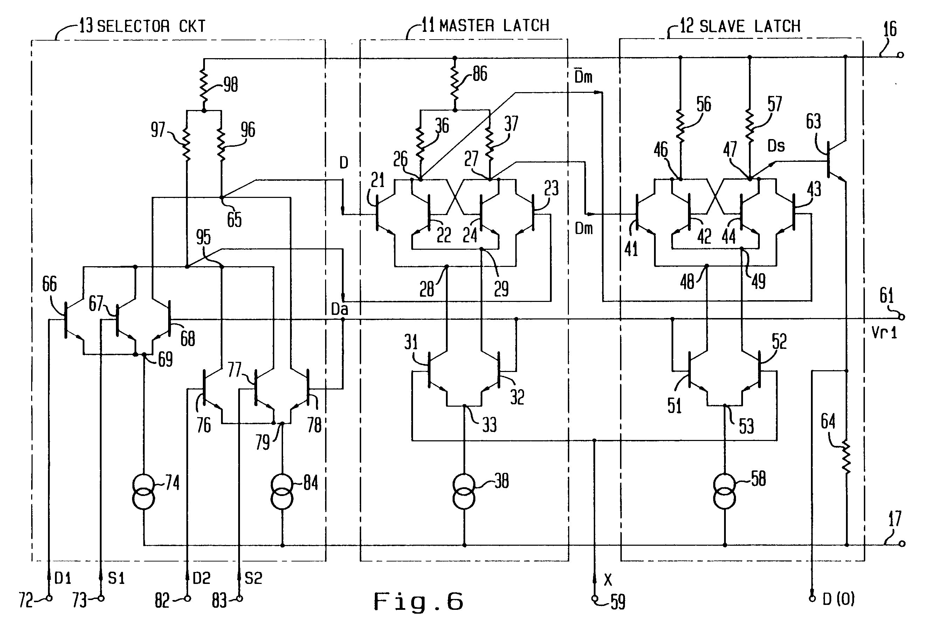

Referring finally to Fig. 6, the description will be directed to a flipflop according to a fifth embodiment of this invention. The flipflop comprises similar parts which are once again designated by like reference numerals and are operable with likewise named and denoted signals.

In the flipflop being illustrated, the additional output signal Da is positively used. More particularly, the selector output signal D is delivered to one of the first and the second primary master transistor circuits as the master input signal and the additional output signal Da, to the other of the first and the second primary master transistor circuits as a reference for the master input signal D. In the example being illustrated, the selector and the additional output signals D and Da are delivered to the base terminals of the input and the reference master transistors 21 and 23. At any rate, the second reference potential Vr2 becomes unnecessary like in the flipflop illustrated with reference to Fig. 4.

In the selector circuit 13 described in conjunction with Fig. 5, it is possible to optionally determine the second selector resistance value Rs2. When it is desired in the master latch circuit 11 being illustrated to use the selector and the additional output signals D and Da as a pair of balanced input signals, the second selector resistance value Rs2 should be determined in consideration of the first selector resistance value Rs1. More specifically, the second selector resistance value Rs2 should be equal in this event to the first selector resistance value Rs1 to render the logic amplitude of the additional output signal Da equal to that of the selector output signal D.

Under the circumstances, the additional output signal Da is given a direct current level shift which becomes considerably great when the predetermined natural number N is great, being equal to ten or more. The second selector resistance value Rs2 should therefore be equal, for example, to an N-th part of the first selector resistance value Rs1 in order that the base electrode of the reference master transistor 23 may not be supplied with too deep a base potential.

Irrespective of the second selector resistance value Rs2, let the master input signal D have the first higher selector logic level. The base potential of the input master transistor 21 becomes substantially equal to the first source potential less the first smaller potential drop NRpsl. Its collector potential

becomes substantially equal to the first source potential less the greater master potential drop (Rpm + Rm)I as before. The base potential is not so higher than the collector potential. This is advantageous in preventing the input master transistor 21 from being saturated.

Preferably, the selector output signal D should have a smaller logic amplitude than the slave output signal Ds. In the master latch circuit 11 described in conjunction with Fig. 5, use of the smaller logic amplitude adversely affects margins against noise, fluctuations in the second reference voltage Vr2, and others. In contrast, use of the additional output signal Da as the reference is meritorious in insuring the margins.

Reviewing Figs. 2 through 6, various combinations are possible among the master and the slave latch circuits 11 and 12 and the selector circuit 13. It is possible to use two or more reference potentials instead of the first reference potential Vr1 in coincidence with the midpoint between the high and the low levels of the clock signal X and the midpoint between the high and the low levels of the input data and/or the select signals. The master latch circuit 11 can be modified to latch the first and the second master latched signals when the clock signal X builds up. In this event, the slave latch circuit 12 should latch the first and the second slave latched signals when the clock signal X builds down. The master output signal Dm may be whichever of the first and the second master latched signals with the first and the second slave latched signals correspondingly used as the slave output signal Ds.

The first master and slave latched signals are inverted relative to the second master and slave latched signals. The individual resistors, such as the first and the second ones 91 and 92, are preferably given a common individual resistance value, which need not be equal to the resistance value of the single resistor 85. When the common individual resistance value is equal to the resistance value of the single resistor 85, one only of the additional output signals, such as Da1 and Da2, is inverted in relation to the selector output signal D while other additional output signal or signals are kept at a predetermined logic level. In Figs. 5 and 6, the additional output signal Da is not a signal which is inverted with respect to the selector output signal D. The master, the slave, and the selector constant currents may have different current values. It should, however, be noted in this connection that the selector constant current values are very preferably equal to one another.

For the flipflops illustrated with reference to Figs. 2 through 6, it will be readily possible to determine the first and the second source potentials, the first and the second reference potentials Vr1 and Vr2, the common slave resistance value Rs, and others in consideration of the conventional flipflop and the description so far made. For example, ground potential is used as the first source potential. The second source potential is equal to minus 5 volts. The common flipflop constant current value I is equal to 5 mA. The common slave resistance value Rs is equal to 100 ohms. The first reference potential Vr1 is equal to about minus 1 volt. In Figs. 2 and 3, the second reference potential Vr2 is equal to about minus 0.25 volt. In Fig. 5, the second reference potential Vr2 depends on the predetermined natural number N and the predetermined and the first selector resistance values Rps and Rs1.

While this invention has thus far been described in specific conjunction with several preferred embodiments thereof, it will now be readily possible for one skilled in the art to carry this invention into effect in other manners. For instance, it is possible to implement each of the first and the second primary and secondary master and slave transistor circuits and the selector transistor circuits in a different way. The fact should be noted in this regard that PNP transistors are seldom used in such a transistor circuit. When field effect transistors are used, the words "base", "emitter", and "collector" should accordingly be understood.

## Claims

1. A flipflop comprising: a master latch circuit (11) comprising first and second master terminals connected to first and second power leads (16, 17), differentially operable first and second primary master transistor circuits (21, 22; 23, 24) having first and second master nodes (26, 27), respectively, a master resistor circuit (36, 37, 86) between said first master terminal and said first and second master nodes, and differentially operable first and second secondary master transistor (31, 32) circuits between said first and second primary master transistor circuits (21, 22; 23, 24) and said second master terminal; a slave latch circuit (12) comprising first and second slave terminals connected to first and second power leads (16, 17), differentially operable first and second primary slave transistor circuits (41, 42; 43, 44) having first and second slave nodes (46, 47), respectively, a slave resistor circuit (56, 57) between said first slave terminal and said first and second slave nodes, and differentially operable first and second secondary slave transistor circuits (51, 52) between said first and second primary slave transistor circuits and said second slave terminal; a selector circuit (13) comprising first and second selector terminals connected to first and second power leads (16, 17), a plurality of selector transistor circuits (66..68; 76...78) having a common node (65) and connected to said second selector terminal, a selector resistor circuit (85) between said first selector terminal and said common node, and means (72; 82) for supplying a plurality of input data to the respective selector transistor circuits; means (38; 58; 74, 84) for making master, slave, and selector constant currents flow between said first and said second master terminals through said master resistor circuit and said first and second primary and secondary master transistor circuits, between said first and said second slave terminals through said slave resistor circuit and said first and second primary and secondary slave transistor circuits, and between said first and second selector terminals through said selector resistor circuit and each of said selector transistor circuits, respectively; selecting means (73, 83) connected to said selector transistor circuits for selecting one of said input data to provide a selector output signal at said common node; selector to master delivering means (D) for delivering said selector output signal to said first and second primary master transistor circuits as a master input signal; latching means connected to said first and second secondary master and slave transistor circuits for latching said master input signal at said first and second master nodes as a master output signal and a slave input signal at said first and second slave nodes as a slave output signal; and master to slave delivering means (Dm) for delivering said master output signal to said first and second primary slave transistor circuits as said slave input signal; characterised in that said master resistor circuit comprises first and second master resistors (36, 37) having their one ends connected to said first and said second master nodes (26, 27), respectively, and their other ends connected collectively to said first master terminal through a common master resistor (86).

2. A flipflop as claimed in Claim 1, wherein said master output signal is given a smaller logic amplitude than said slave output signal.

3. A flipflop as claimed in Claim 2, said slave resistor circuit having a slave resistance value between said first slave terminal and each of said first and said second slave nodes, said master and said slave constant currents having a common current value, wherein each of said first and said second master resistors has a master resistance value which is substantially equal to a half of said slave resistance value, said common master resistor having a resistance value which is substantially equal to a half of said master resistance value.

4. A flipflop as claimed in Claim 1, wherein said master to slave delivering means is for delivering said master output signal to one of said first and said second primary slave transistor circuits as said slave input signal.

5. A flipflop as claimed in Claim 4, wherein each of said master and said selector output signals is given a smaller logic amplitude than said slave output signal.

6. A flipflop as claimed in Claim 5, said slave resistor circuit having a slave resistance value between said first slave terminal and each of said first and said second slave nodes, said master, said slave, and said selector constant currents having a common current value, wherein each of said first and said second master resistors has a master resistance value which is substantially equal to a half of said slave resistance value, said common master resistor having a resistance value which is substantially equal to a half of said master resistance value, said selector resistor circuit having a selector resistance value between said first selector terminal and said common node, said selector resistance value being substantially equal to said master resistance value.

7. A flipflop as claimed in Claim 1, said latching means latching said master input signal at said first and said second master nodes as first and second latched signals, respectively, said first and said second latched signals being related to said master input signal according to one and the other of positive logic and negative logic, respectively, wherein said master to slave delivering means is for delivering said first latched signal to one of said first and said second primary slave transistor circuits as said slave input signal and said second latched signal to the other of said first and said second primary slave transistor circuits as a reference for said slave input signal.

8. A flipflop as claimed in Claim 7, wherein said selector to master delivering means is for delivering said selector output signal to one of said first and said second primary master transistor circuit as said master input signal.

9. A flipflop as claimed in Claim 8, wherein each of said master and said selector output signals is given a smaller logic amplitude than said slave output signal.

10. A flipflop as claimed in Claim 9, said slave resistor circuit having a slave resistance value between said first slave terminal and each of said first and said second slave nodes, said master, said slave, and said selector constant currents having a common current value, wherein each of said first and said second master resistors has a master resistance value which is substantially equal to a half of said slave resistance value, said common master resistor having a resistance value which is substantially equal to a half of said master resistance value, said selector resistor circuit having a selector resistance value between said first selector terminal and said common node, said selector resistance value being substantially equal to said master resistance value.

11. A flipflop as claimed in Claim 7, said selector transistor circuits having individual nodes, respectively, said selecting means providing said selector output signal at said common node according to one of positive logic and negative logic relative to said one of the input data, wherein said selector resistor circuit comprises a single resistor between said first selector terminal and said common node and individual resistors between said first selector terminal and the respective individual nodes, said selecting means providing an additional output signal according to the other of said positive logic and said negative logic relative to said one of the input data at one of said individual nodes that is had by one of said selector transistor circuits to which said one of the input data is supplied, said selector to master delivering means being for delivering said selector output signal to one of said first and said second primary master transistor circuits directly as said master input signal and said additional output signal to the other of said first and said second primary master transistor circuits through a NOR gate as a reference for said master input signal.

12. A flipflop as claimed in Claim 11, wherein each of said master and said selector output signals has a smaller logic amplitude than said slave output signal, said additional output signal having a logic amplitude which is substantially not greater than said smaller logic amplitude.

13. A flipflop as claimed in Claim 12, said slave resistor circuit having a slave resistance value between said first slave terminal and each of said first and said second slave nodes, said master, said slave, and said selector constant currents having a common current value, wherein each of said first and said second master resistors has a master resistance value which is substantially equal to a half of said slave resistance value, said common master resistor having a resistance value which is substantially equal to a half of said master resistance value, said single resistor having a selector resistance value which is substantially equal to said master resistance value, each of said individual resistors having a resistance value which is not substantially greater than said selector resistance value.

14. A flipflop as claimed in Claim 7, wherein said selector transistor circuits have an additional node in common, said selector resistor circuit comprising first and second selector resistors having their one ends connected to said common and said additional nodes, respectively, and their other ends connected collectively to said first selector terminal through a common selector resistor, said selecting means being for providing said selector output signal at said common node according to one of positive logic and negative logic relative to said one of the input data and an additional output signal at said additional node according to the other of said positive logic and said negative logic relative to said one of the input data.

15. A flipflop as claimed in Claim 14, wherein said selector to master delivering means is for delivering said selector output signal to one of said first and said second primary master transistor circuits as said master input signal.

16. A flipflop as claimed in Claim 15, wherein each of said master and said selector output signals has a smaller logic amplitude than said slave output signal.

17. A flipflop as claimed in Claim 16, said slave resistor circuit having a slave resistance value between said first slave terminal and each of said first and said second slave nodes, said master, said slave, and said selector constant currents having a common current value, said selector transistor circuits being N in number, where N represents a predetermined natural number, wherein each of said first and said second master resistors has a master resistance value which is substantially equal to a half of said slave resistance value, said common master resistor having a resistance value which is substantially equal to a half of said master resistance value, said first selector resistor having a selector resistance value which is substantially equal to a resistance value selected between said slave resistance value, exclusive, and said master resistance value, inclusive, said common selector resistor having a resistance value which is substantially equal to an N-th part of said selector resistance value.

18. A flipflop as claimed in Claim 14, wherein said selector to master delivering means is for delivering said selector output signal to one of said first and said second primary master transistor circuits as said master input signal and said additional output signal to the other of said first and said second primary master transistor circuits as a reference for said master input signal.

19. A flipflop as claimed in Claim 18, wherein each of said master and said selector output signals has a smaller logic amplitude than said slave output signal, said additional output signal having a logic amplitude which is not substantially greater than said smaller logic amplitude.

20. A flipflop as claimed in Claim 19, said slave resistor circuit having a slave resistance value between said first slave terminal and each of said first and said second slave nodes, said master, said slave, and said selector constant currents having a common current value, said selector transistor circuits being N in number, where N represents a predetermined natural number, wherein each of said first and said second master resistors has a master resistance value which is substantially equal to a half of said slave resistance value, said common master resistor having a resistance value which is substantially equal to a half of said master resistance value, said first selector resistor having a first selector resistance value which is substantially equal to a resistance value selected between said slave resistance value, exclusive, and said master resistance value, inclusive, said second selector resistor having a second selector resistance value which is substantially equal to a resistance value selected between an entirety and an N-th part of said first selector resistance value, both inclusive, said common selector resistor having a resistance value which is substantially equal to an N-th part of said first selector resistance value.

**Patentansprüche**

1. Flipflop, das aufweist: eine Master-Halteschaltung (11), die aufweist erste und zweite Master-Anschlüsse, die mit ersten und zweiten Stromversorgungsanschlüssen (16, 17) verbinden sind, differentiell betreibbare erste und zweite primäre Master-Transistorschaltungen (21, 22; 23, 24) mit ersten bzw. zweiten Master-Knoten (26, 27), eine Master-Widerstandsschaltung (36, 37, 86) zwischen dem ersten Master-Anschluß und dem ersten und zweiten Master-Knoten und differentiell betreibbare erste und zweite sekundäre Master-Transistorschaltungen (31, 32) zwischen den ersten und zweiten primären Master-Transistorschaltungen (21, 22; 23, 24) und dem zweiten Master-Anschluß; eine Slave-Halteschaltung (12) mit ersten und zweiten Slave-Anschlüssen, die mit den ersten und zweiten Stromversorgungsanschlüssen (16, 17) verbunden sind, differentiell betreibbaren ersten und zweiten primären Slave-Transistorschaltungen (41, 42; 43, 44) mit ersten bzw. zweiten Slave-Knoten (46, 47), einer Slave-Widerstandschaltung (56, 57) zwischen dem ersten Slave-Anschluß und den ersten und zweiten Slave-Knoten und differentiell betreibbaren ersten und zweiten sekundären Slave-Transistorschaltungen (51, 52) zwischen den ersten und zweiten primären Slave-Transistorschaltungen und dem zweiten Slave-Anschluß; eine Selektor-Schaltung (13) mit ersten und zweiten Selektor-Anschlüssen, die mit den ersten und zweiten Stromversorgungsanschlüssen (16, 17) verbunden sind, einer Vielzahl von Selektor-Transistorschaltungen (66..68; 76...78), die einen gemeinsamen Knoten (65) haben und mit dem zweiten Selektor-Anschluß verbunden sind, einer Selektor-Widerstandsschaltung (85) zwischen dem ersten Selektor-Anschluß und dem gemeinsamen Knoten und einer Einrichtung (72; 82) zum Zuführen einer Vielzahl von Eingabedaten zu den jeweiligen Selektor-Transistorschaltungen; eine Einrichtung (38; 58; 74, 84) zum Veranlassen, daß Master-, Slave- und Selektor-Konstantströme zwischen den ersten und zweiten Master-Anschlüssen durch die Master-Widerstandsschaltung und die ersten und zweiten primären und sekundären Master-Transistorschaltungen, zwischen den ersten und zweiten Slave-Anschlüssen durch die Slave-Widerstandsschaltung und die ersten und zweiten primären und sekundären Slave-Transistorschaltungen bzw. zwischen den ersten und zweiten Selektor-Anschlüssen durch die Selektor-Widerstandsschaltung und jede der Selektor-Transistorschaltungen fließen; eine Auswahleinrichtung (73, 83), die mit den Selektor-Transistorschaltungen verbunden ist, zum Auswählen einer der Eingabedaten, um ein Selektor-Ausgangssignal an dem gemeinsamen Knoten zu erzeugen, eine Selektor-zu-Master-Zuführeinrichtung (D) zum Zuführen des Selektor-Ausgangssignals zu den ersten und zweiten primären Master-Transistorschaltungen als Master-Eingangssignal; eine Halteeinrichtung, die mit den ersten und zweiten sekundären Master- und Slave-Transistorschaltungen zum Halten des Master-Eingangssignals an den ersten und zweiten Master-Knoten als ein Master-Ausgangssignalund eines Slave-Eingangssignals an den ersten und zweiten Slave-Knoten als ein Slave-Ausgangssignal verbunden ist; und eine Master-zu-Slave-Züführeinrichtung (Dm) zum Zuführen des Master-Ausgangssignals zu den ersten und zweiten primären Slave-Transistorschaltungen als das Slave-Eingangssignal; dadurch gekennzeichnet, daß die Master-Widerstandsschaltung erste und zweite Master-Widerstände (36, 37) aufweist, die mit ihren einen Enden mit den ersten bzw. zweiten Master-Knoten (26, 27) verbunden sind und die mit ihren anderen Enden zusammen mit dem ersten Master-Anschluß über einen gemeinsamen Master-Widerstand (86) verbunden sind.

2. Flipflop, wie in Anspruch 1 definiert, worin das Master-Ausgangssignal eine kleinere logische Amplitude hat als das Slave-Ausgangssignal.

3. Flipflop, wie in Anspruch 2 beansprucht, wobei die Slave-Widerstandsschaltung einen Slave-Widerstandswert zwischen dem ersten Slave-Anschluß und jedem der ersten und zweiten Slave-Knoten hat, wobei die Master- und Slave-Konstantströme einen gemeinsamen Stromwert haben, und wobei jeder der ersten und zweiten Master-Widerstände einen Master-Widerstandswert hat, der im wesentlichen gleich der Hälfte des Slave-Widerstandswertes ist, und der gemeinsame Master-Widerstand einen Widerstandswert hat, der im wesentlichen gleich der Hälfte des Master-Widerstandswerts ist.

4. Flipflop, wie in Anspruch 1 beansprucht, worin die Master-zu-Slave-Zuführeinrichtung zum Zuführen des Master-Ausgangssignals zu einer der ersten und zweiten primären Slave-Transistorschaltungen als Slave-Eingangssignal vorgesehen ist.

5. Flipflop, wie in Anspruch 4 beansprucht, worin jedes der Master- und Selektor-Ausgangssignale eine kleinere logische Amplitude hat als das Slave-Ausgangssignal.

6. Flipflop, wie in Anspruch 5 beansprucht, wobei die Slave-Widerstandsschaltung einen Slave-Widerstandswert zwischen dem ersten Slave-Anschluß und jedem der ersten und zweiten Slave-Knoten hat, wobei die Master-, Slave- und Selektor-Konstantströme einen gemeinsamen Stromwert haben, wobei jeder der ersten und zweiten Master-Widerstände einen Master-Widerstand hat, der im wesentlichen gleich der Hälfte des Slave-Widerstandswerts ist, wobei der gemeinsame Master-Widerstand einen Widerstandswert hat, der im wesentlichen gleich der Hälfte des Master-Widerstandswerts ist, und wobei die Selektor-Widerstandsschaltung einen Selektor-Widerstandswert zwischen dem ersten Selektor-Anschluß und dem gemeinsamen Knoten hat und der Selektor-Widerstandswert im wesentlichen gleich dem Master-Widerstandswert ist.

7. Flipflop, wie in Anspruch 1 beansprucht, wobei die Halteeinrichtung das Master-Eingangssignal an den ersten und zweiten Master-Knoten als erste bzw. zweite gehaltene Signale hält, wobei die ersten und zweiten gehaltenen Signale auf das Master-Eingangssignal gemäß der einen oder der anderen von der positiven bzw. negativen Logik bezogen sind, wobei die Master-zu-Slave-Zuführeinrichtung zum Zuführen des ersten gehaltenen Signals zu der einen der ersten und zweiten primären Slave-Transistorschaltungen als das Slave-Eingangssignal und zum Zuführen des zweiten gehaltenen Signals zu der anderen der ersten und zweiten primären Slave-Transistorschaltungen als Referenz für das Slave-Eingangssignal vorgesehen ist.

8. Flipflop, wie in Anspruch 7 beansprucht, worin die Selektor-zu-Master-Zuführeinrichtung zum Zuführen des Selektor-Ausgangssignals zu der einen der ersten und zweiten primären Master-Transistorschaltungen als Master-Eingangssignal vorgesehen ist.

9. Flipflop, wie in Anspruch 8 beansprucht, worin jedes der Master- und Selektor-Ausgangssignale eine niedrigere logische Amplitude hat, als das Slave-Ausgangssignal.

10. Flipflop, wie in Anspruch 9 beansprucht, wobei die Slave-Widerstandsschaltung einen Slave-Widerstandswert zwischen dem ersten Slave-Anschluß und jedem der ersten und zweiten Slave-Knoten hat, wobei die Master-, Slave-, und Selektor-Konstantströme einen gemeinsamen Stromwert haben, wobei jeder der ersten und zweiten Master-Widerstände einen Master-Widerstandswert hat, der im wesentlichen gleich der Hälfte des Slave-Widerstandswerts ist, wobei der gemeinsame Master-Widerstand einen Widerstandswert hat, der im wesentlichen die Hälfte des Master-Widerstandswerts hat, wobei die Selektor-Widerstandsschaltung einen Selektor-Widerstandswert zwischen dem ersten Selektor-Anschluß und dem gemeinsamen Knoten hat und wobei der Selektor-Widerstandswert im wesentlichen gleich dem Master-Widerstandswert ist.

11. Flipflop, wie in Anspruch 7 beansprucht, wobei die Selektor-Transistorschaltungen jeweils individuelle Knoten haben und wobei die Auswahleinrichtung, die das Selektor-Ausgangssignal an dem gemeinsamen Knoten gemäß der einen der positiven Logik und der negativen Logik bezüglich der einen der Eingangsdaten erzeugt, wobei die Selektor-Widerstandsschaltung einen einzelnen Widerstand zwischen dem ersten Selektor-Anschluß und dem gemeinsamen Knoten und individuelle Widerstände zwischen dem ersten Selektor-Anschluß und den jeweiligen individuellen Knoten hat, wobei die Auswahleinrichtung ein zusätzliches Ausgangssignal gemäß der anderen Logik von der positiven Logik und der negativen Logik bezüglich der einen der Eingangsdaten an einem der individuellen Knoten erzeugt, der in einer der Selektor-Transistorschaltungen liegt, welcher die einen der Eingangsdaten zugeführt werden, wobei die Selektor-zuMaster-Zuführeinrichtung zum Zuführen des Selektor-Ausgangssignals zu einer aus den ersten und zweiten primären Master-Transistorschaltungen direkt als Master-Eingangssignal und als zusätzliches Ausgangssignal zu der anderen aus den ersten und zweiten primären Master- Transistorschaltungen über ein NOR-Gatter als Referenz für das Master-Eingangssignal vorgesehen ist.

12. Flipflop, wie in Anspruch 11 beansprucht, worin jedes der Master- und Selektor-Ausgangssignale eine niedrigere logische Amplitude als das Slave-Ausgangssignal hat und wobei das zusätzliche Ausgangssignal eine logische Amplitude hat, die im wesentlichen nicht größer als diese niedrigere logische Amplitude ist.

13. Flipflop, wie in Anspruch 12 beansprucht, wobei die Slave-Widerstandsschaltung einen Slave-Widerstandswert zwischen dem ersten Slave-Anschluß und jedem der ersten und zweiten Slave-Knoten hat, wobei die Master-, Slave-und Selektor-Konstantströme einen gemeinsamen Stromwert haben, wobei jeder der ersten und zweiten Master-Widerstände einen Master-Widerstandswert hat, der im wesentlichen gleich der Hälfte des Slave-Widerstandswerts ist, wobei der gemeinsame Master-Widerstand einen Widerstandswert hat, der im wesentlichen gleich der Hälfte des Master-Widerstandswerts ist, wobei der einzelne Widerstand einen Selektor-Widerstandswert hat, der im wesentlichen gleich dem Master-Widerstandswert ist und wobei die individuellen Widerstände einen Widerstandswert haben, der nicht wesentlich größer als der Selektor-Widerstandswert ist.

14. Flipflop, wie in Anspruch 7 beansprucht, worin die Selektor-Widerstandschaltungen einen zusätzlichen gemeinsamen Knoten haben, wobei die Selektor-Widerstandsschaltung erste und zweite Selektor-Widerstände haben, deren eines Ende mit dem gemeinsamen bzw. zusätzlichen Knoten verbunden sind und deren andere Enden zusammen mit dem ersten Selektor-Anschluß über einen gemeinsamen Selektor-Widerstand verbunden sind, wobei die Auswahleinrichtung zum Erzeugen des Selektor-Ausgangssignals an dem gemeinsamen Knoten gemäß einer Logik aus der positiven Logik und negativen Logik bezüglich der einen der Eingangsdaten und eines zusätzlichen Ausgangssignals an den zusätzlichen Knoten gemäß der anderen Logik aus der positiven und der negativen Logik bezüglich der einen der Eingangsdaten vorgesehen ist.

15. Flipflop, wie in Anspruch 14 beansprucht, worin die Selektor-zu-Master-Zuführeinrichtung zum Zuführen des Selektor-Ausgangssignals zu einer aus den ersten und zweiten primären Master-Transistorschaltungen als Master-Eingangssignal vorgesehen ist.

16. Flipflop, wie in Anspruch 15 beansprucht, worin jedes der Master- und Selektor-Ausgangssignale eine niedrigere logische Amplitude, als das Slave-Ausgangssignal hat.

17. Flipflop, wie in Anspruch 16 beansprucht, wobei die Slave-Widerstandsschaltung einen Slave-Widerstandswert zwischen einem ersten Slave-Anschluß und jedem der ersten und zweiten Slave-Knoten hat, wobei die Master-, Slave-, und Selektor-Konstantströme einen gemeinsamen Stromwert haben, wobei N Selektor-Transistorschaltungen vorgesehen sind, wobei N eine vorgegebene natürliche Zahl ist, wobei jeder der ersten und zweiten Master-Widerstände einen Master-Widerstandswert hat, der im wesentlichen gleich der Hälfte des Slave-Widerstandswerts ist, wobei der gemeinsame Master-Widerstand einen Widerstandswert hat, der im wesentlichen gleich der Hälfte des Master-Widerstandswerts ist, wobei der erste Selektor-Widerstand einen Selektor-Widerstandswert hat, der im wesentlichen gleich dem Widerstandswert ist, der zwischen dem Slave-Widerstandswert, exklusive, und dem Master-Widerstandswert, inklusive, ausgewählt ist, wobei der gemeinsame Selektor-Widerstand einen Widerstandswert hat, der im wesentlichen gleich einem N-ten Teil des Selektor-Widerstandswertes ist.

18. Flipflop, wie in Anspruch 14 beansprucht, wobei die Selektor-zu-Master-Zuführeinrichtung zum Zuführen des Selektor-Ausgangssignals zu einer der ersten und zweiten primären Master-Transistorschaltungen als das Master-Eingangssignal und des zusätzlichen Ausgangssignals zu der anderen der ersten und zweiten primären Master-Transistorschaltungen als Referenz für das Master-Eingangssignal vorgesehen ist.

19. Flipflop, wie in Anspruch 18 beansprucht, wobei jedes der Master- und Selektor-Ausgangssignale eine niedrigere logische Amplitude als das Slave-Ausgangssignal hat und wobei das zusätzliche Ausgangssignal eine logische Amplitude hat, die nicht wesentlich größer als diese niedrigere logische Amplitude ist.

20. Flipflop, wie in Anspruch 19 beansprucht, wobei die Slave-Widerstandsschaltung einen Slave-Widerstandswert zwischen dem ersten Slave-Anschluß und jedem der ersten und zweiten Slave-Knoten hat, wobei die Master-, Slave- und Selektor-Konstantströme einen gemeinsamen Stromwert haben, wobei N Selektor-Transistorschaltungen vorgesehen sind, wobei N eine vorgegebene natürliche Zahl ist, wobei jeder der ersten und zweiten Master-Widerstände einen Master-widerstandswert hat, der im wesentlichen gleich der Hälfte des Slave-Widerstandswerts ist, wobei der gemeinsame Master-Widerstand einen Widerstandswert hat, der im wesentlichen gleich der Hälfte des Master-Widerstandswertes ist, wobei der erste Selektor-Widerstand einen ersten Selektor-Widerstandswert hat, der im wesentlichen gleich dem Widerstandswert ist, der zwischen dem Slave-Widerstandswert, exklusive, und dem Master-Widerstandswert, inklusive, ausgewählt ist, wobei der zweite Selektor-Widerstand einen zweiten Selektor-Widerstandswert hat, der im wesentlichen gleich dem Widerstandswert ist, der zwischen der Gesamtheit oder einem N-ten Teil des ersten Selektor-Widerstandswertes, beide inklusive, ausgewählt ist, wobei der Selektor-Widerstand einen Widerstandswert hat, der im wesentlichen gleich einem N-ten Teil des ersten Selektor-Widerstandswertes ist.

## Revendications

1. Bascule comprenant : un circuit d'enclenchement maître (11) comportant des première et seconde bornes maîtres reliées à des premier et second fils de puissance (16, 17), des premier et second circuits à transistors maîtres primaires pouvant fonctionner différentiellement (21, 22; 23, 24) ayant des premier et second noeuds maîtres (26, 27), respectivement, un circuit à résistances maîtres (36, 37, 86) entre ladite première borne maître et lesdits premier et second noeuds maîtres, et des premier et second circuits à transistor maître secondaire pouvant fonctionner différentiellement (31, 32) entre lesdits premier et second circuits à transistors maîtres primaires (21, 22; 23, 24) et ladite seconde borne maître; un circuit d'enclenchement esclave (12) comportant des première et seconde bornes esclaves reliées aux premier et second fils de puissance (16, 17), des premier et second circuits à transistors esclaves primaires (41, 42; 43, 44) ayant des premier et second noeuds esclaves (46, 47) respectivement, un circuit à résistances esclaves (56, 57) entre ladite première borne esclave et lesdits premier et second noeuds esclaves, et des premier et second circuits à transistor esclave secondaire pouvant fonctionner différentiellement (51, 52) entre lesdits premier et second circuits à transistors esclaves primaires et ladite seconde borne esclave; un circuit de sélecteur (13) comportant des première et seconde bornes de sélecteur reliées aux premier et second fils de puissance (16, 17), une multitude de circuits à transistors de sélecteur (66...68; 76... 78) ayant un noeud commun (65) et reliés à ladite seconde borne de sélecteur, un circuit à résistance de sélecteur (85) entre ladite première borne de sélecteur et ledit noeud commun, et un moyen (72, 82) pour fournir une multitude de données d'entrée aux circuits respectifs à transistors de sélecteur; un moyen (38; 58; 74, 84) pour provoquer le passage de courants constants maître, esclave et de sélecteur entre lesdites première et seconde bornes maîtres par l'intermédiaire dudit circuit à résistances maîtres et desdits premier et second circuits à transistor maître secondaires, entre lesdites première et seconde bornes esclaves par l'intermédiaire dudit circuit à résistances esclaves et desdits premier et second circuits à transistors esclaves primaires et à transistor esclave secondaire, et entre lesdites première et seconde bornes de sélecteur par l'intermédiaire dudit circuit à résistance de sélecteur et de chacun desdits circuits à transistors de sélecteur, respectivement; un moyen de sélection (73, 83) relié auxdits circuits à transistors de sélecteur pour sélectionner l'une desdites données d'entrée afin de fournir un signal de sortie de sélecteur audit noeud commun; un moyen (D) de délivrance de sélecteur à maître pour délivrer ledit signal de sortie de sélecteur auxdits premier et second circuits à transistors maîtres primaires comme signal d'entrée maître; un moyen d'enclenchement relié auxdits premier et second circuits à transistor maître secondaire et à transistor esclave secondaire pour enclencher ledit signal d'entrée maître auxdits premier et second noeuds maîtres comme signal de sortie maître et un signal d'entrée esclave auxdits premier et second noeuds esclaves comme signal de sortie esclave; et un moyen (Dm) de délivrance de maître à esclave pour délivrer ledit signal de sortie maître auxdits premier et second circuits à transistors esclaves primaires comme ledit signal d'entrée esclave; caractérisée en ce que ledit circuit à résistances maîtres comprend des première et seconde résistances maîtres (36, 37) ayant leurs premières extrémités connectées auxdits premier et second noeuds maîtres (26, 27), respectivement, et leurs autres extrémités reliées collectivement à ladite première borne maître par l'intermédiaire d'une résistance maître commune (86).

2. Bascule selon la revendication 1, dans laquelle ledit signal de sortie maître reçoit une amplitude logique inférieure à celle dudit signal de sortie esclave.

3. Bascule selon la revendication 2, ledit circuit à résistances esclaves ayant une valeur de résistance esclave entre ladite première borne esclave et chacun desdits premier et second noeuds esclaves, lesdits courants constants maître et esclave ayant une valeur commune du courant, où chacun desdites première et seconde résistances maîtres a une valeur de résistance maître qui est sensiblement égale à la moitié de ladite valeur de résistance esclave, ladite résistance maître commune ayant une valeur de résistance qui est sensiblement égale à la moitié de ladite valeur de résistance maître.

**4.** Bascule selon la revendication 1, dans laquelle ledit moyen de délivrance de maître à esclave sert à délivrer ledit signal de sortie maître à l'un des premier et second circuits à transistors esclaves primaires comme ledit signal d'entrée esclave.

**5.** Bascule selon la revendication 4, dans laquelle chacun desdits signaux de sortie maître et de sélecteur reçoit une amplitude logique inférieure à celle dudit signal de sortie esclave.

**6.** Bascule selon la revendication 5, ledit circuit à résistances esclaves ayant une valeur de résistance esclave entre ladite première borne esclave et chacun desdits premier et second noeuds esclaves, lesdits courants constants maître, esclave et de sélecteur ayant une valeur de courant commune, où chacune desdites première et seconde résistances maîtres a une valeur de résistance maître qui est sensiblement égale à la moitié de ladite valeur de résistance esclave, ladite résistance maître commune ayant une valeur de résistance qui est sensiblement égale à la moitié de ladite valeur de résistance maître, ledit circuit à résistance de sélecteur ayant une valeur de résistance de sélecteur entre ladite première borne de sélecteur et ledit noeud commun, ladite valeur de résistance de sélecteur étant sensiblement égale à ladite valeur de résistance maître.

**7.** Bascule selon la revendication 1, ledit moyen d'enclenchement enclenchant ledit signal d'entrée maître auxdits premier et second noeuds maîtres comme premier et second signaux enclenchés, respectivement, lesdits premier et second signaux enclenchés étant liés audit signal d'entrée maître conformément à l'un et l'autre d'un niveau logique positif et d'un niveau logique négatif, respectivement, où ledit moyen de délivrance de maître à esclave sert à délivrer ledit premier signal enclenché à l'un desdits premier et second circuits à transistors esclaves primaires comme ledit signal d'entrée esclave et ledit second signal enclenché à l'autre des premier et second circuits à transistors esclaves primaires comme référence pour ledit signal d'entrée esclave.

**8.** Bascule selon la revendication 7, dans laquelle ledit moyen de délivrance de sélecteur à maître sert à délivrer ledit signal de sortie de sélecteur à l'un desdits premier et second circuits à transistors maîtres primaires comme ledit signal d'entrée maître.

**9.** Bascule selon la revendication 8, dans laquelle chacun desdits signaux de sortie maître et de sélecteur reçoit une amplitude logique inférieure à celle dudit signal de sortie esclave.

**10.** Bascule selon la revendication 9, ledit circuit à résistances esclaves ayant une valeur de résistance esclave entre ladite première borne esclave et chacun desdits premier et second noeuds esclaves, lesdits courants constants maître, esclave et de sélecteur ayant une valeur commune du courant, où chacune desdites première et seconde résistances maîtres a une valeur de résistance maître qui est sensiblement égale à la moitié de ladite valeur de résistance esclave, ladite résistance maître commune ayant une valeur de résistance qui est sensiblement égale à la moitié de ladite valeur de résistance maître, ledit circuit à résistance de sélecteur ayant une valeur de résistance de sélecteur entre ladite première borne de sélecteur et ledit noeud commun, ladite valeur de résistance de sélecteur étant sensiblement égale à ladite valeur de résistance maître.

**11.** Bascule selon la revendication 7, lesdits circuits à transistors de sélecteur ayant des noeuds individuels, respectivement, ledit moyen de sélection fournissant ledit signal de sortie de sélecteur audit noeud commun conformément à l'un des niveau logique positif et d'un niveau logique négatif relatif à ladite une des données d'entrée, où ledit circuit à résistance de sélecteur comprend une seule résistance entre ladite première borne de sélecteur et ledit noeud commun et des résistances individuelles entre ladite première borne de sélecteur et les noeuds individuels respectifs, ledit moyen de sélection fournissant un signal de sortie additionnel conformément à l'autre dudit niveau logique positif et dudit niveau logique négatif relatifs à ladite une des données d'entrée à l'un desdits noeuds individuels qui a été eu par l'un desdits circuits à transistors de sélecteur auquel ladite une des données d'entrée est fournie, ledit moyen de délivrance de sélecteur à maître servant à délivrer directement ledit signal de sortie de sélecteur à l'un desdits premier et second circuits à transistors maîtres primaires comme ledit signal d'entrée maître et ledit signal de sortie additionnel à l'autre desdits premier et second circuits à transistors maîtres primaires par l'intermédiaire d'une porte NON OU comme référence pour ledit signal d'entrée maître.

**12.** Bascule selon la revendication 11, dans laquelle chacun desdits signaux maître et de sortie de sélecteur a une amplitude logique inférieure à celle dudit signal de sortie esclave, ledit signal de sortie additionnel ayant une amplitude logique qui n'est pas sensiblement supérieure à ladite amplitude logique plus petite.

13. Bascule selon la revendication 12, ledit circuit à résistances esclaves ayant une valeur de résistance esclave entre ladite première borne esclave et chacun desdits premier et second noeuds esclaves, lesdits courants constants maître, esclave et de sélecteur ayant une valeur commune du courant, où chacune desdites première et seconde résistances maîtres a une valeur de résistance maître qui est sensiblement égale à la moitié de ladite valeur de résistance esclave, ladite résistance maître commune ayant une valeur de résistance qui est sensiblement égale à la moitié de ladite valeur de résistance maître, ladite résistance unique ayant une valeur de résistance de sélecteur qui est sensiblement égale à ladite valeur de résistance maître, chacune desdites résistances individuelles ayant une valeur de résistance qui n'est pas sensiblement supérieure à ladite valeur de résistance de sélecteur.

14. Bascule selon la revendication 7, dans laquelle lesdits circuits à transistors de sélecteur ont un noeud supplémentaire en commun, ledit circuit à résistances de sélecteur comportant des première et seconde résistances de sélecteur ayant une de leurs extrémités reliée auxdits noeuds commun et supplémentaire, respectivement, et leurs autres extrémités connectées collectivement à ladite première borne de sélecteur par l'intermédiaire d'une résistance de sélecteur commune, ledit moyen de sélection servant à fournir ledit signal de sortie de sélecteur audit noeud commun conformément à l'un d'un niveau logique positif et d'un niveau logique négatif relatifs à ladite une des données d'entrée et un signal de sortie additionnel audit noeud supplémentaire conformément à l'autre dudit niveau logique positif et dudit niveau logique négatif relatifs à ladite une des données d'entrée.

15. Bascule selon la revendication 14, dans laquelle ledit moyen de délivrance de sélecteur à maître sert à délivrer ledit signal de sortie de sélecteur à l'un desdits premier et second circuits à transistors maîtres primaires comme ledit signal d'entrée maître.

16. Bascule selon la revendication 15, où chacun desdits signaux de sortie maître et de sélecteur a une amplitude logique plus petite que celle dudit signal de sortie esclave.

17. Bascule selon la revendication 16, ledit circuit à résistances esclaves ayant une valeur de résistance esclave entre ladite première borne esclave et chacun desdits premier et second noeuds esclaves, lesdits courants constants maître, esclave et de sélecteur ayant une valeur commune du courant, lesdits circuits à transistors de sélecteur étant N en nombre où N représente un nombre naturel prédéterminé, où chacune desdites première et seconde résistances maîtres a une valeur de résistance maître qui est sensiblement égale à la moitié de ladite valeur de résistance esclave, ladite résistance maître commune ayant une valeur de résistance qui est sensiblement égale à la moitié de ladite valeur de résistance maître, ladite première résistance de sélecteur ayant une valeur de résistance de sélecteur qui est sensiblement égale à une valeur de résistance choisie entre ladite valeur de résistance esclave, non comprise, et ladite valeur de résistance maître, comprise, ladite résistance de sélecteur commune ayant une valeur de résistance qui est sensiblement égale à une N-ème partie de ladite valeur de résistance de sélecteur.

18. Bascule selon la revendication 14, dans laquelle ledit moyen de délivrance de sélecteur à maître sert à délivrer ledit signal de sortie de sélecteur à l'un desdits premier et second circuits à transistors maîtres primaires comme ledit signal d'entrée maître et ledit signal de sortie additionnel à l'autre desdits premier et second circuits à transistors maîtres primaires comme référence pour ledit signal d'entrée maître.

19. Bascule selon la revendication 18, dans laquelle chacun desdits signaux de sortie maître et de sélecteur a une amplitude logique plus petite que celle dudit signal de sortie esclave, ledit signal de sortie additionnel ayant une amplitude logique qui n'est pas sensiblement supérieure à ladite amplitude logique plus petite.

20. Bascule selon la revendication 19, ledit circuit à résistances esclaves ayant une valeur de résistance esclave entre ladite première borne esclave et chacun desdits premier et second noeuds esclaves, les courants constants maître, esclave et de sélecteur ayant une valeur commune du courant, lesdits circuits à transistors de sélecteur étant N en nombre où N représente un nombre naturel prédéterminé, où chacune desdites première et seconde résistances maîtres a une valeur de résistance maître qui est sensiblement égale à la moitié de ladite valeur de résistance esclave, ladite résistance maître commune ayant une valeur de résistance qui est sensiblement égale à la moitié de ladite valeur de résistance maître, ladite première résistance de sélecteur ayant une valeur de première résistance de sélecteur qui est sensiblement égale à une valeur de résistance choisie entre ladite valeur de résistance esclave, non comprise, et ladite valeur de résistance maître, comprise, ladite seconde résistance de sélecteur ayant une valeur de seconde résistance de sélecteur qui est sensiblement égale à une valeur de résistance choisie entre la totalité et une N-ème partie de ladite valeur de la première résistance de sélecteur, toutes deux comprises, ladite résistance de sélecteur commune ayant une valeur de résistance qui est sensiblement égale à une N-ème partie de ladite valeur de la première résistance de sélecteur.

PRIOR ART

Fig. 1

Fig.2

Fig.3

Fig.4

EP 0 305 941 B1

Fig.5

EP 0 305 941 B1

Fig.6

29